# EUROPEAN PATENT APPLICATION

(11) **EP 1 806 781 A1**
(43) Date of publication of application: **11.07.2007**
(21) Application number: 06100214.3
(22) Date of filing: 10.01.2006
(51) Int. Cl.: H01L 21/768, H01L 23/532, H01L 23/522

(54) **Conductive interconnect with a localized overhanging dielectric barrier**

(71) Applicant: STMicroelectronics ( Crolles 2) SAS, 38920 Crolles (FR)
(72) Inventor: Bustos, Jessy, 38660, LE TOUVET (FR); Chhun, Sonarith, 73800, MONTMELIAN (FR)
(74) Representative: de Beaumont, Michel

(57) **Abstract**

The invention concerns an integrated circuit comprising at least one interconnect layer, the interconnect layer comprising a first conductive track and a first localized barrier formed over the first conductive track, the width of the first localized barrier being wider than the width of the first conductive track such that the first localized barrier overhangs the first conductive track.

## Description

### FIELD OF THE INVENTION

The present invention relates to a conductive interconnect formed over a semiconductor substrate, and in particular to a conductive interconnect having a localized barrier, and to a method of forming the same.

### BACKGROUND OF THE INVENTION

The propagation speeds of signals along interconnects in integrated circuits (ICs) are an important factor in the overall circuit speed. In particular, in very and ultra large scale integration (VLSI and ULSI) circuits, it is particularly important that the metal conductors forming the interconnects are of low resistance. Copper is a preferred metal for these interconnects as it has low resistance. However, copper suffers from high diffusivity in certain materials such as silicon oxide and certain polymers, and therefore a copper diffusion barrier is required surrounding the copper interconnects.

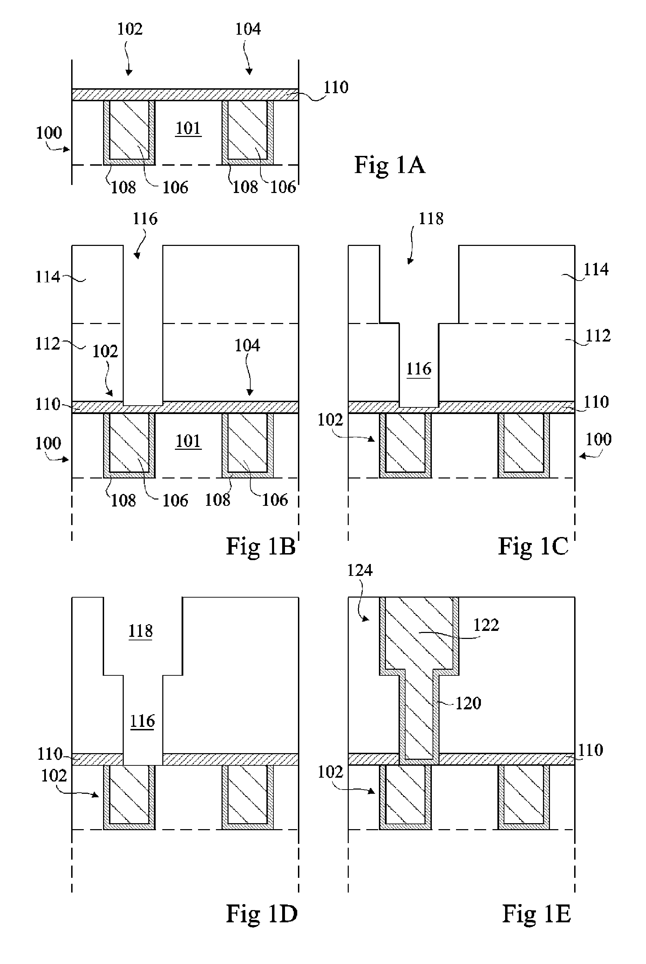

Referring to figure 1A, a cross-section view of an interconnect layer 100 of a multi-layer interconnect is shown comprising a layer 101 of insulating material, a first conductive track 102 and a second conductive track 104. The insulating material is for example silicon oxide (SiO₂). Each conductive track comprises a copper track 106, surrounded by a metallic barrier 108, formed for example of tantalum (Ta), tantalum nitride (TaN) or titanium nitride (TiN). An etch stop layer 110 has been formed over the insulating layer 100 and the conductive tracks 102, 104. This layer is formed of, for example, silicon carbide (SiC), silicon carbonitride (SiCN) or silicon nitride (SiN). Etch stop layer 110 helps the control of a via etch as will be explained in more detail below. It also provides a dielectric capping to the copper 106 of the conductive tracks, preventing diffusion of the copper.

Figures 1B to 1E illustrate steps in forming a via connecting the first conductive track 102 to a conductive track formed on a higher level.

As shown in figure 1B, a layer of silicon oxide is deposited over the interconnect layer 100 and etch stop layer 110, forming an insulating layer 112, and a further interconnect layer 114. In a first step a via etch is performed, forming a hole 116 down towards the first conductive track 102. The via is misaligned with respect to the conductive track 102, and thus the via etch is also misaligned. The via etch stops when the etch stop layer 110 is reached, this layer stopping the etch penetrating further.

Referring to figure 1C, a track etch is then performed. This track etch forms a trench 118 which will be used to form the conductive track in interconnect layer 114. Trench 118 is wider than hole 116, but only penetrates to approximately the boundary between the insulating layer 112 and the interconnect layer 114.

Next, as shown in figure 1D, the dielectric barrier 110 is opened using a plasma etch in the bottom of the hole 116.

Finally, referring to figure 1E, a metallic barrier 120 is deposited lining the hole 116 and trench 118, and a copper track 122 is deposited within the metallic barrier 120. Chemical mechanical polishing (CMP) is then performed to remove any excess barrier material or copper. A connection has thus been formed between track 102, and a newly formed track 124. It should be noted that even though the via was misaligned with the conductive track 102, due to the etch stop layer 110, a good connection with the conductive track is still possible.

The problem with the above method is that the material for the etch stop layer 110 is generally selected to be one of either SiN, SiC or SiNC. Such materials have a high permittivity or dielectric constant k, which in particular is higher than the permittivity of the insulating material 100 which is selected for having a low k. Thus the etch stop layer 110 increases the parasitic capacitance between the first and second conductive tracks 102 and 104.

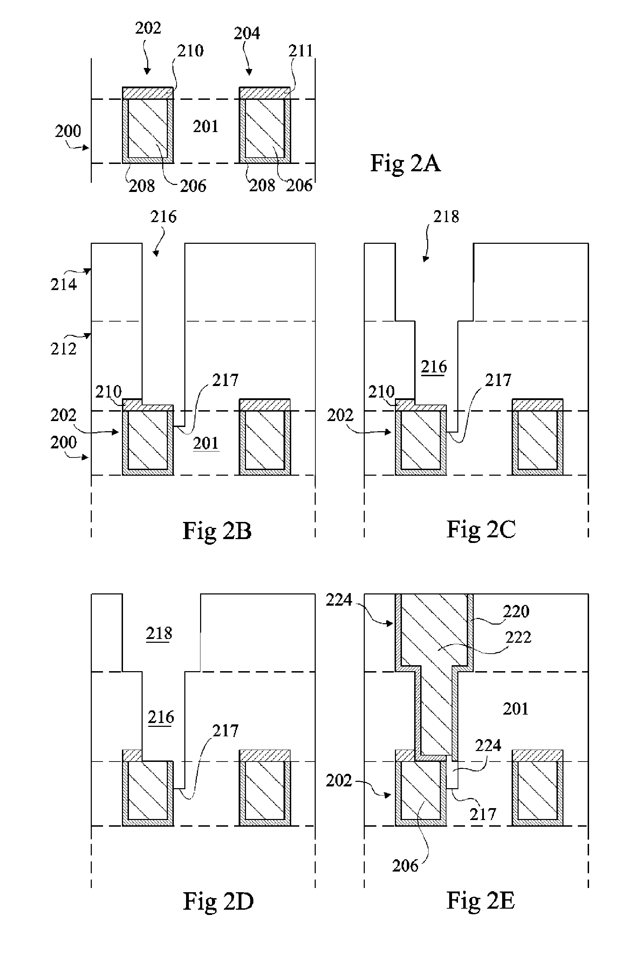

A solution to this problem is to use a localized etch stop or dielectric barrier covering the conductive tracks. Figure 2A illustrates such an embodiment. Referring to figure 2A, a cross-section view of an interconnect layer 200 of a multi-layer interconnect is shown comprising an insulating material 201, a first conductive track 202 and a second conductive track 204. The insulating material 201 is for example silicon oxide (SiO₂). Each conductive track comprises a copper track 206, surrounded by a metallic barrier 208, formed for example of tantalum (Ta), tantalum nitride (TaN) or titanium nitride (TiN). Localized dielectric barriers 210, 211 have been formed over the insulating layer 200 covering each of the conductive tracks 202, 204. As with etch stop layer 110 of figure 1, barriers 210, 211 are formed of, for example, silicon carbide (SiC), silicon carbonitride (SiCN) or silicon nitride (SiN), and may be formed by a process using an additional mask, or using self-aligned barriers, for example CoWP, NiMoP or CuSiN W-CVD.

Providing localized dielectric barriers 210, 211 results in a lower permittivity between the first and second conductive tracks 202, 204, however these localized barriers present a problem when the via is misaligned with the conductive track, as will now be described.

Figure 2B to 2E illustrate steps in forming a via connecting the first conductive track 202 to a conductive track on a higher level, and in particular the result of a misaligned via.

As shown in figure 2B, a layer of silicon oxide is deposited over the interconnect layer 200, forming an insulating layer 212, and a further interconnect layer 214. In a first step a via etch is performed, forming a hole 216 down towards the first conductive track 202. The via is misaligned with the conductive track 202. The via etch is stopped by the localized barrier 210 of the first conductive track 202, however, due to the misalignment of the via, a part of the etch misses the dielectric barrier, and penetrates further into the insulating material 201 of layer 200, to one side of the conductive track 202, forming a deeper hole 217.

Referring to figure 2C, a track etch is then performed. This track etch forms a trench 218 which will be used to form the conductive track in interconnect layer 214. Trench 218 is wider than hole 216, but only penetrates to approximately the boundary between the insulating layer 212 and the interconnect layer 214. The bottom of the hole 216 is also exposed to the track etch. Dielectric barrier 210 acts as a stop to the track etch, however region 217, to the side of the barrier 210, is unprotected and thus region 217 is deepened by the track etch.

Next, as shown in figure 2D, the localized dielectric barrier 210 is opened using a plasma etch in the bottom of the hole 116. This also has the effect of deepening hole 217.

Finally, referring to figure 2E, a metallic barrier 220 is deposited lining the hole 216 and trench 218, and a copper track 222 is deposited within the metallic barrier 220. Chemical mechanical polishing (CMP) is then performed to remove any excess barrier material or copper. A connection has thus been formed between track 202, and a newly formed track 224. However, due to the misalignment of the via, a void 224 remains to the side of the first conductive track 202.

This void leads to bad metallization, and results in a reduction of the interconnect lifetime due to the electromigration phenomenon which is accelerated due to the void. The void provides a route through which the copper of the copper track 206, or the copper 222 of the via can diffuse into the insulating material 201, unprotected by the metallic barrier, leading to possible short circuits.

### SUMMARY OF THE INVENTION

The present invention aims to at least partially address the above problems discussed in relation to the prior art.

According to a first aspect of the present invention there is provided an integrated circuit comprising at least one interconnect layer, the interconnect layer comprising a first conductive track and a first localized barrier formed over said first conductive track, the width of said first localized barrier being wider than the width of said first conductive track such that said first localized barrier overhangs said first conductive track.

According to a further aspect of the present invention, there is provided a method of forming an overhanging localized barrier over a conductive track comprising the steps of forming a barrier layer over an insulating layer comprising said conductive track, forming a resist over said barrier layer, applying radiation to said resist such that said radiation is reflected by said conductive track, said reflected radiation penetrating a first region of said resist, wherein only said first region of said resist receives sufficient radiation to reach a development threshold of said resist, developing said resist and etching said barrier using said developed resist as a mask.

### BRIEF DESCRIPTION OF THE DRAWINGS

The foregoing and other purposes, features, aspects and advantages of the invention will become apparent from the following detailed description of a number of embodiments which is given by way of illustration only without limiting the invention, and throughout which reference is made to the accompanying drawings in which:
figures 1A to 1E (described above) illustrate in cross-section view a known structure for an interconnect layer and steps in a method of connecting a via to said interconnect;
figures 2A to 2E (also described above) illustrate in cross-section view a known structure for an interconnect layer and steps in a method of connecting a via to said interconnect;
figures 3A to 3J are cross-section views illustrating the steps in forming an interconnect structure according to an embodiment of the present invention; and
figures 4A to 4D illustrate the steps in connecting a via to the interconnect of figure 3J according to one embodiment.

For reasons of clarity, same elements in the figures have been referenced with the same reference numbers throughout the figures. Furthermore, as is usual with the representation of integrated circuits, the figures have not been drawn to scale.

### DETAILED DESCRIPTION OF THE INVENTION

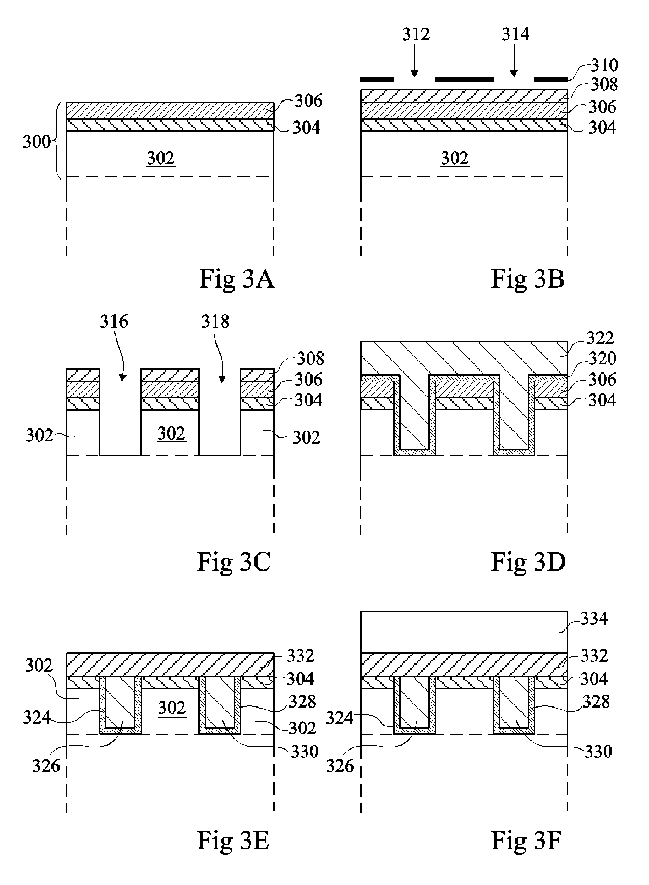

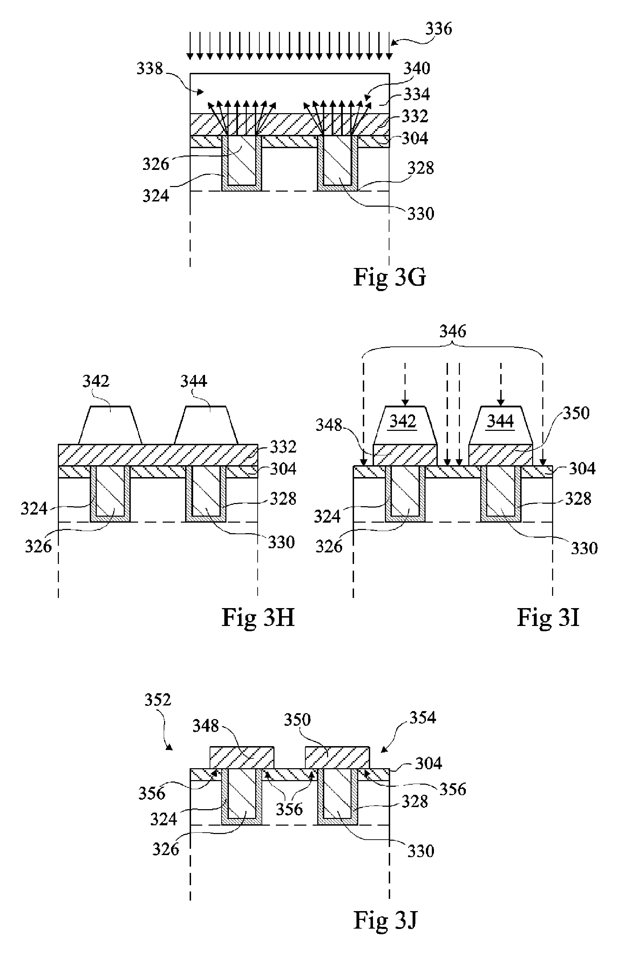

Referring to figures 3A to 3J, the steps in a method of forming conductive tracks, each having an overhanging localized dielectric barrier, are illustrated by a series of cross-section views illustrating a pair of such tracks. By overhanging, it is meant that the localized dielectric barrier formed over a conductive track is wider than the width of the track, and thus overhangs both sides.

With reference to figure 3A, in a first step an interconnect layer 300 is formed comprising an insulating material 302, which comprises for example, silicon oxide (SiO₂). The insulating material preferably has a low or ultra low permittivity constant k. The layer of insulating material is covered by an anti-reflective dielectric layer 304. The anti-reflective dielectric layer comprises, for example, a bottom anti-reflective coating (BARC), and is a material suitable for absorbing photolithography radiation, for reasons that will be explained in more detail below. The anti-reflective layer is formed of, for example a suitable polymer material.

A hard mask layer 306 is deposited over the anti-reflective layer 304. In alternative embodiments, no anti-reflective layer 304 is provided, and the hard mask layer 306 is deposited directly onto the insulating layer 302.

Next, as shown in figure 3B, a resist layer 308 is deposited over the hard mask 306, and a mask layer 310 is formed over the resist 308, the mask 310 having two openings 312 and 314 determining the area in which the conductive tracks will be formed. It will be apparent that in alternative examples in which more than two conductive tracks are required, a different mask will be used with more openings to form the tracks.

Next, referring to figure 3C, photolithography and plasma etching is performed, which, due to the openings 312 and 314 in the mask layer 310, results in respective first and second trenches 316 and 318 being formed through the resist layer 308, through the hard mask layer 306, and into the insulating layer 302.

Next, with reference to figure 3D, the resist layer 308 is removed, and a metallic barrier layer 320 is deposited over the device, covering hard mask layer 306 and lining the first and second trenches 316, 318. The metallic barrier comprises, for example, TaN, TaN/Ta or TiN. Copper 322 is then deposited over the metallic barrier 320, filling the first and second trenches 316, 318.

Referring to figure 3E, in a next step, chemical mechanical polishing is performed to remove a top layer of copper and the hard mask, down to the top surface of anti-reflective layer 304, or the insulating layer 302 if there is no anti-reflective surface provided. Thus, the metallic barrier layer only remains in first and second trenches, forming metallic barriers 324 and 328. The copper also only remains in the first and second trenches, forming copper tracks 326 and 330.

A dielectric barrier layer 332 is then deposited over the device, covering the tops of the conductive tracks. The dielectric barrier comprises, for example, SiC, SiCN or SiN.

Next, as shown in figure 3F, a negative resist layer 334, sensitive to UV radiation, is deposited over the dielectric barrier layer 332.

As shown in figure 3G, the structure is then illuminated with UV radiation 336. This UV radiation penetrates the negative resist 334. However, this radiation alone is not sufficient to cause the negative resist to reach the development threshold.

However, this radiation is reflected from the top surface of the copper tracks 326, 330. Due to the nature of copper, the surfaces of the first and second copper tracks reflect the UV radiation, causing the two clusters of reflected radiation 338, 340 above copper track 326 and 330 respectively. This reflected radiation also penetrates the negative resist layer 334, and causes the regions receiving this reflected UV radiation to reach the development threshold.

Thus, as shown in figure 3H, after development, the negative resist layer 334 is removed except in two regions 342 and 344 above the first and second copper tracks 326, 330 respectively, these regions being the areas that received the reflected light in a sufficient quantity.

As a next step, a directional plasma etch is performed as shown in figure 3I, which removes the dielectric barrier layer 332 in regions unprotected by the resist portions 342 and 344.

As shown in figure 3J, next the resists 342 and 344 are removed. This leaves two conductive tracks 352 and 354 each being covered by a localized dielectric barrier 348 and 350. Each of the localized dielectric barriers 348, 350 overhangs the top surface of the respective copper track 326, 330 and metallic barrier 324, 328 on each side, the dielectric barriers being wider than the respective copper tracks. The overhanging portions are indicated in figure 3J by arrows 356.

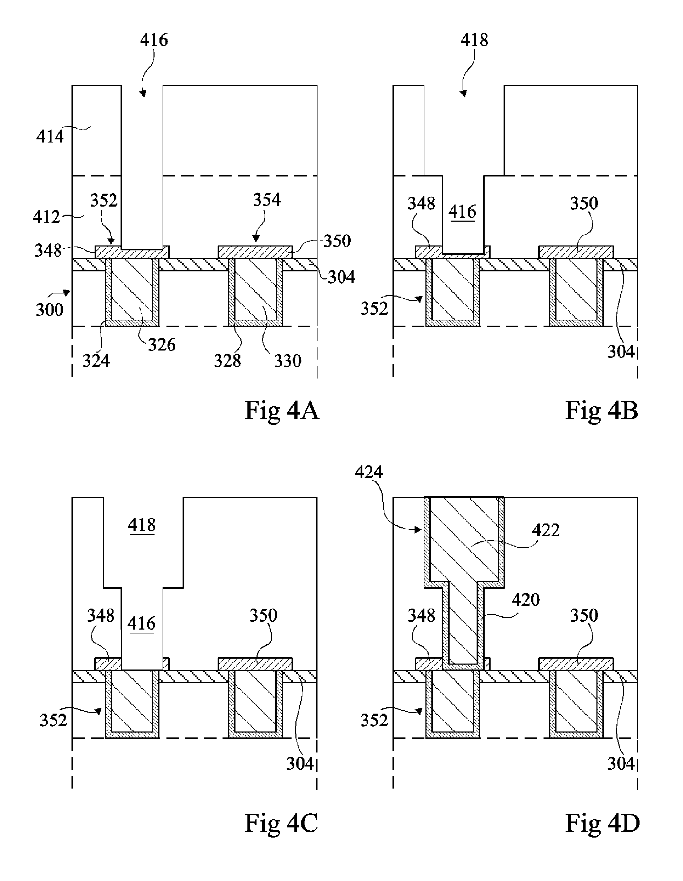

Figures 4A to 4D are cross-section views illustrating steps in connecting the conductive track 352 of figure 3J to a conductive track of a higher level in the multi-layer interconnect, by forming a via. In particular these figures illustrate the result of a misaligned via being formed above a conductive track having an overhanging localized dielectric barrier.

Referring to figure 4A, a layer of silicon oxide is deposited over the interconnect layer 300 and anti-reflective layer 304, forming an insulating layer 412, and a further interconnect layer 414. In a first step a via etch is performed, forming a hole 416 down towards the first conductive track 352. The via is misaligned with the conductive track 352, meaning that the via etch is also misaligned. The via etch stops when the localized dielectric barrier 348 is reached, this barrier stopping the etch penetrating further. Due to the overhang of the localized barrier 348, the misaligned via does not miss the barrier, despite the misalignment.

Referring to figure 4B, a track etch is then performed. This track etch forms a trench 418 which will be used to form the conductive track in interconnect layer 414. Trench 418 is wider than hole 416, but only penetrates to approximately the boundary between the insulating layer 412 and the interconnect layer 414.

Next, as shown in figure 4C, the dielectric barrier 348 is opened using a plasma etch in the bottom of the hole 416.

Finally, referring to figure 4D, a metallic barrier 420 is deposited lining the hole 416 and trench 418, and copper is deposited within the metallic barrier 420, forming a copper track 422. Chemical mechanical polishing (CMP) is then performed to remove any excess barrier material or copper. A connection has thus been formed between track 326, and a newly formed track 424. It should be noted that even though the via was misaligned with the conductive track 326, a good connection is still made due to the overhanging localized dielectric barrier 348, which also acts as an etch stop. Thus a via is formed with no void.

The overhang of the dielectric barriers 348 and 350 over the first and second conductive tracks is achieved by the reflected UV radiation during the lithography step described in relation to figure 3G, that does not only occur in a direction directly parallel to the original UV radiation, but disperses to the sides. This sideways reflection causes the negative resist to reach the development threshold not only in regions directly above the copper tracks, but also in regions to either side, thus enabling the dielectric barrier layer to be removed leaving localised dielectric barriers formed with an overhang.

This method of forming the overhanging barriers has the advantage that the localised barrier is automatically aligned with the copper track.

The width of the overhang can be controlled during the photolithography step by adjusting the duration of UV radiation, a longer duration resulting in a wider overhang. Alternatively, the development threshold of the negative resist can be adjusted, provided that the development threshold can not be reached without the reflected radiation. Alternatively, the baking duration and/or temperature of the resist before development can be increased to increase the overhang width. All of these parameters may be varied to provide a required overhang that is sufficiently wide to solve any misalignment problems described above, but ensuring sufficient spacing between one localized dielectric barrier and the next so that they do not make contact, which would increase the parasitic capacitance between the conductive channels.

By way of example, the approximate dimensions of the copper tracks 326, 330 are 100nm in width, and 220nm in depth, and the approximate dimensions of the overhanging localized dielectric barrier are 40nm in depth, and 140nm in width, thus providing an overhang of approximately 20nm on each side of the copper track. The length of the track and the route it follows across the integrated circuit will depend on the design of the integrated circuit.

Thus an embodiment of an overhanging localized dielectric barrier, and an example of a method of forming the same have been described. It will be obvious to those skilled in the art that there are many possible variations to the method used to form the dielectric barrier.

Although the conducting tracks have been described as being formed of copper, these tracks can be formed of other metals or conducting materials. It is only necessary that the material of the conducting track provides some reflection to the UV radiation applied during the photolithography step.

Although a number of examples of materials have been provided for the localized barrier, the substrate and the metallic barrier, other materials are possible. The localized barrier and the metallic barrier can be formed of a dielectric material, thus forming dielectric barriers as described above, or alternatively they could be formed of conducting materials.

Whilst an anti-reflective layer 201 can be provided in some methods, in other methods no anti-reflective layer is provided. If there is a sufficient difference in the reflective properties of the insulating material, for example formed of SiO₂, and the track, for example formed of copper, no anti-reflective layer is required. However, if there is insufficient difference between the UV reflectivity of the insulating layer 302 and the conductive track, an anti-reflective layer can be applied to provide sufficient difference in reflectivity.

In the embodiment described in relation to figure 3 above, the anti-reflective layer remains in the insulating layer around the metal tracks in the finished interconnect. If this is the case, it is important that the anti-reflective layer has a low permittivity constant k, which is for example approximately that of the insulating layer, such that it does not significantly increase the permittivity across the layer 300, thus increasing parasitic capacitance. Alternatively a very thin anti-reflective coating could be used to minimize permittivity.

In alternative embodiments, the anti-reflection layer, or part of it, is removed after formation of the localized barrier. This could be achieved, for example, by using a wet etch after the plasma etch in the step shown in figure 3I.

According to the embodiment described above, UV radiation is used to develop the negative resist. For example wavelengths of 248nm or 193nm are possible, or lower wavelengths could be used if immersion lithography or e-Beam technology is used, allowing better resolution and smaller features. Alternatives to UV radiation are also possible.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. An integrated circuit comprising at least one interconnect layer (300), the interconnect layer comprising:
a first conductive track (326); and
a first localized barrier (348) formed over said first conductive track, the width of said first localized barrier being wider than the width of said first conductive track such that said first localized barrier overhangs said first conductive track.

2. The integrated circuit of claim 1 wherein said first conductive track is formed in a layer of insulating material (302), and further comprising an anti-reflective layer (304) formed over said insulating layer and not over said conductive track.

3. The integrated circuit of claim 1 wherein said localized barrier is formed of a dielectric material.

4. The integrated circuit of claim 1 wherein said interconnect layer further comprises a second conductive track (330) adjacent to said first conductive track, and a second localized barrier (350) formed over said second conductive track, the width of said second localized barrier being wider than the width of said second conductive track such that said second localized barrier overhangs said first conductive track, said first and second localized barriers being separated from each other by a spacing.

5. The integrated circuit of claim 1 wherein said conductive track comprises copper.

6. A method of forming an overhanging localized barrier (348, 350) over a conductive track (326, 330) comprising the steps of:
forming a barrier layer (332) over an insulating layer (302) comprising said conductive track;
forming a resist (334) over said barrier layer;
applying radiation (336) to said resist such that said radiation is reflected by said conductive track, said reflected radiation penetrating a first region (342, 344) of said resist, wherein only said first region of said resist receives sufficient radiation to reach a development threshold of said resist;
developing said resist; and
etching said barrier using said developed resist as a mask.

7. The method of claim 6, comprising, before said step of forming said barrier layer, the steps of:
depositing an anti-reflective layer (304) over said insulating layer, said anti-reflective layer for absorbing said radiation;
forming a trench (316, 318) through said anti-reflective layer into said insulating layer; and
depositing a conductive material into said trench to form said conductive track.

8. The method of claim 6 wherein said radiation is UV radiation.
